# EUROPEAN PATENT APPLICATION

(11) **EP 0 999 588 A2**
(43) Date of publication of application: **10.05.2000**
(21) Application number: 99402768.8
(22) Date of filing: 08.11.1999
(51) Int. Cl.: H01L 23/31

(54) **Semiconductor device and method for assembling the same**

(30) Priority: 06.11.1998 JP 31645798
(71) Applicant: SONY CORPORATION, Tokyo (JP)
(72) Inventor: Ozaki, Hiroshi, Shinagawa-ku, Tokyo (JP)
(74) Representative: Thévenet, Jean-Bruno

(57) **Abstract**

External terminals (6) are electrically connected to a semiconductor chip (2) via a polyimide tape (4) having a conductive layer (4b) sandwiched between polyimide layers (4a, 4c). The external terminals (6) are electrically connected to the conductive layer (4b) provided on one surface thereof. Pads (2a) of the semiconductor chip (2) and the conductive layer (4b) are connected by solder (10) on the other surface thereof. A resin (12) is filled in the entire area in an interval between the facing semiconductor chip (2) and polyimide tape (4) including the periphery of the connection portions.

The invention reduces the manufacturing cost by reducing the material cost and the number of manufacturing steps in a CSP (chip size packaging) technology using a polyimide tape for an intermediate substrate for providing an external terminal and prevents mechanical shock from being applied to a semiconductor chip as much as possible.

## Description

### BACKGROUND OF THE INVENTION

### 1. Field of the Invention

The present invention relates to a semiconductor device enabling a chip size packaging which packages the semiconductor device in a small size as much as possible to the size of the chip by achievement of connection of solder balls or other external terminals and a semiconductor chip via a polyimide tape, and a method for assembling the same.

### 2. Description of the Related Art

As high density mounting technologies of a semiconductor device, there is known a chip size package (hereinafter simply referred to as a CSP) technology where a bare chip is mounted on one surface of a polyimide tape and solder balls and other external terminals are provided on the other surface.

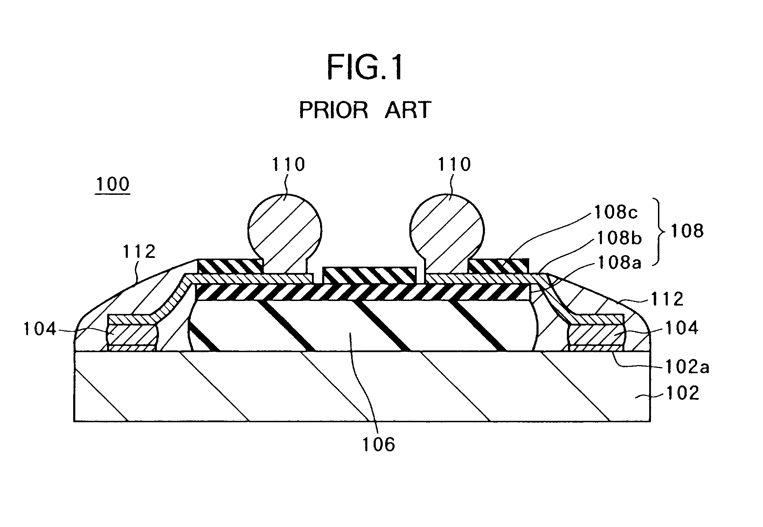

Figure 1 is a sectional view of the schematic configuration of a semiconductor device produced by using this CSP technique.

In this CSP semiconductor device 100, a polyimide tape 108 is fixed on a semiconductor chip 102 via an elastomer 106. The elastomer 106 is a bonding member having elasticity, and therefore functions as a buffer member for absorbing stress due to the difference in thermal expansion coefficient between a mother board for mounting the CSP semiconductor device 100 and the semiconductor chip 102. The polyimide tape 108 has a three-layer structure of a polyimide base 108a, a Cu film 108b, and a polyimide protection layer 108c and is used as an intermediate substrate when forming the external terminals on a semiconductor chip 102.

Front end portions of the Cu film 108b are connected onto pads 102a of the semiconductor chip 102 via bumps 104 made of for example Au. The periphery of the elastomer 106 and the polyimide tape 108 containing the connection portions is covered by a resin 112.

Solder balls 110 serving as the external terminals are formed at an exposed portion of the Cu film 108b of the polyimide tape 108.

In the production of the CSP semiconductor device 100, the Au bumps 104 are formed on the pads 102a at regions of the semiconductor chip 102 in a wafer state. Specifically. Au stud bumps are formed by using a wire bonding device or Au bumps are formed by electroplating. In this state, the elastomer 106 is adhered to a predetermined position by for example a printing process, then the polyimide tape 108 is positioned with and bonded to the elastomer 106. The front ends of the beam lead portions of the Cu film 108b are then ultrasonically thermocompression bonded to electrically and mechanically connect a predetermined pattern portion of the Cu film 108b onto the predetermined pads 102a via the Au bumps 104. Thereafter, for improvement of the reliability, the resin 112 is injected so as to surround the periphery of the connection portions and cover the exposed parts of the element forming surface of the semiconductor chip 102, whereby the CSP 100 finishes being assembled.

In such a semiconductor device and assembly method, however, the process of adhering the polyimide tape 108 to the semiconductor chip 102 via the elastomer 106, brings the high material cost of the elastomer 106 a complex production, a long production time, and the resultant high cost of the CSP semiconductor device.

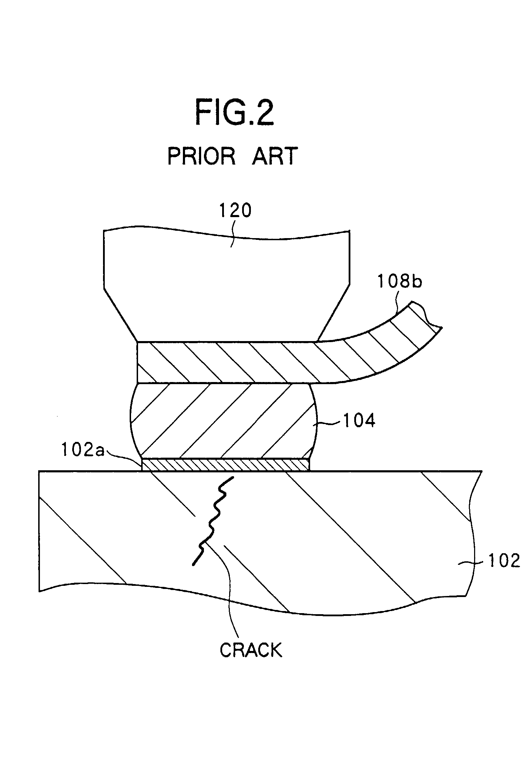

Especially, it is found that the elastomer 106 cannot fully absorb the stress due to the difference in thermal expansion coefficients of the mother board and the semiconductor chip, the resultant cracks may occur in the solder balls 110 at an early stage after the semiconductor device was mounted on the mother board. Furthermore, when the Cu film 108b of the polyimide tape 108 and the pads 102a of the semiconductor chip 102 are connected by using Au bumps 104 as in the illustrated example, this connection is carried out by ultrasonic thermocompression bonding, therefore, as shown in Fig. 2, cracks may occur in the semiconductor chip 102 under the pads 102a due to the pressing force and vibration of a tool 120.

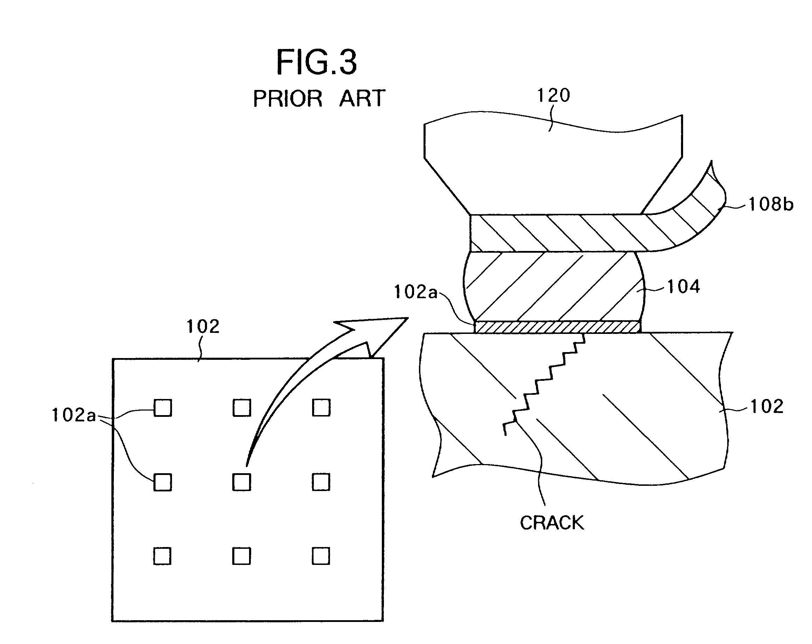

Note, the pads 102a sometimes are not arranged at the circumferential portion of the semiconductor chip, but are arranged over the entire area of the semiconductor chip in the form of a grid array in recent CPU's as shown in Fig. 3. In a semiconductor device in which pads are arranged in the form of the grid array, a semiconductor element is often formed beneath a pad 102a. In this case, the semiconductor element may be broken due to mechanical stress at the time of ultrasonic thermocompression bonding. This reduces the yield and the reliability of the semiconductor device.

### SUMMARY OF THE INVENTION

An object of the present invention is to provide a semiconductor device having an external terminal connected to a semiconductor chip via an intermediate conductive member, having a resistance (tolerance) to mechanical and/or thermal stress.

Another object of the present invention is to provide a semiconductor device having the above structure, and having a reduced size and an improved reliability.

Still another object of the present invention is to provide a method for assembling the semiconductor device at a high reliability and the resultant improved yield.

Yet still another object of the present invention is to provide a method for assembling the semiconductor device with a simple manner, at a short time, and at a low cost.

A semiconductor device according to the present invention is a semiconductor device comprising a semiconductor chip external terminal electrically connected to the semiconductor chip via a polyimide tape having a conductive layer and two polyimide layers with the conductive layer sandwiched therebetween, wherein said external terminal for electrical connection to said conductive layer of the polyimide tape is provided on one surface of the polyimide tape, and wherein a pad of the semiconductor chip and the conductive layer of the polyimide tape is connected by solder on the other surface of the polyimide tape.

Preferably, a resin is filled in the entire area inside a gap of the facing semiconductor chip and polyimide tape including the periphery of the connection positions of the semiconductor chip and the polyimide tape.

The method for assembling a semiconductor device according to the present invention is a method for assembling a semiconductor device in which an external terminal is electrically connected to a semiconductor chip via a polyimide tape having a conductive layer and two polyimide layers with the conductive layer sandwiched therebetween, including the steps of: supplying solder onto a pad of the semiconductor chip or an electrode layer provided on the pad; positioning so that a predetermined location of the conductive layer exposed at one surface of the polyimide tape is positioned on top of the solder; and connecting the polyimide tape and the semiconductor chip by thermocompression bonding.

Preferably, it further includes the steps of: filling a resin in the entire area inside an interval of the facing semiconductor chip and polyimide tape including the periphery of the connection positions of the semiconductor chip and the polyimide tape and forming an external terminal at a predetermined location of the conductive layer exposed at the other surface of the polyimide tape.

Another method for assembling a semiconductor device according to the present invention is a method for assembling a semiconductor device in which an external terminal is electrically connected to a semiconductor chip via a polyimide tape having a conductive layer and two polyimide layers with the conductive layer sandwiched therebetween, including the steps of: supplying solder onto a pad in the state of the semiconductor wafer before it is divided into chips or an electrode layer is provided on the pad; positioning so that a predetermined location of the conductive layer exposed at one surface of the polyimide tape is positioned on top of the solder; connecting the polyimide tape and the semiconductor chip by thermocompression bonding; and dividing the semiconductor wafer into chips.

The polyimide tape used in the connection step of the polyimide tape and the semiconductor wafer can be divided into chip regions or can be connected over the entire area of the semiconductor wafer. In the latter case, the polyimide tape is divided together with the semiconductor wafer in the step of dividing the semiconductor wafer into chips.

Furthermore, preferably, it further includes the steps of: filling a resin in the entire area inside an interval of the facing semiconductor wafer and polyimide tape including the periphery of the connection positions of the semiconductor wafer and the polyimide tape: and forming an external terminal at a predetermined location of the conductive layer exposed at the other surface of the polyimide tape.

In this resin filling step, preferably a plurality of resin injecting nozzles are used to inject resin all together on the entire surface of the semiconductor wafer or for a plurality of chip regions in a predetermined area, and, in the step of dividing the semiconductor wafer into chips, the resin part between chip regions is cut together with the semiconductor wafer.

Furthermore, preferably, in the connection step of the polyimide tape and the semiconductor wafer, when holding one of the polyimide tape and the semiconductor wafer and pressing the same against the other, a tool (or a support stand) having such an elasticity that it can absorb a repulsion force due to pressing to a certain extent may be used.

In such a semiconductor device and method for assembling the same according to the present invention, the portions of the conductive layer exposed at one surface of the polyimide tape and the pads of the semiconductor chip are connected by solder. At this time, since for example an elastomer or other bonding layer is not interposed between the polyimide tape and the semiconductor chip, the material cost is cheaper and the number of manufacturing steps is smaller than those of the prior art by that amount.

Note that the elastomer which has been used in the past was provided for relieving the stress due to the difference in thermal expansion coefficients between the semiconductor chip and the substrate (mother board) to which it is to be mounted, but in the present invention the stress is sufficiently relieved by the injection of the resin, so the elastomer is omitted.

Furthermore, due to the solder connection, electrical and mechanical connection of the polyimide tape and the semiconductor chip can be achieved just by applying processing for improving the solder wettability to the conductive layer of the polyimide tape according to need and lightly pressing the same after heating. That is, it is not necessary to apply a high frequency wave as in the prior art and perform the thermocompression bonding with a considerably high pressing force, so the force added to the semiconductor chip becomes smaller by that amount.

According to the present invention, there is also provided a semiconductor device comprising: a semiconductor chip; an electrical-conductive portion having a pad formed on the surface of the semiconductor chip, bump metal layer formed on the pad and a solder layer formed on the bump metal layer; an intermediate electrical-conductive member having an electrical conductive layer and first and second insulation layers formed on both surfaces of the electrical conductive layer, and facing the surface of the semiconductor chip; an insulation resin inserted in a gap between the semiconductor chip and the intermediate electrical-conductive member; and an external terminal. One surface of the electrical conductive layer of the intermediate electrical-conductive member is connected to the solder layer of the electrical-conductive portion through an opening formed in the first insulation layer of the intermediate electrical-conductive member and another surface of the electrical conductive layer of the intermediate electrical-conductive member is connected to the external terminal through another opening formed in the second insulation layer of the intermediate electrical-conductive member.

### BRIEF DESCRIPTION OF THE DRAWINGS

These and other objects and features of the present invention will become clearer from the following description of the preferred embodiments given with reference to the accompanying drawings, in which:
Fig. 1 is a sectional view of a schematic configuration of the related art semiconductor device;
Fig. 2 is an enlarged view of a connection part of a beam lead and a semiconductor chip in the assembly of the related art semiconductor device;
Fig. 3 is an enlarged view of a pattern of arrangement of pads of the related art semiconductor device in which pads are arranged over the entire area of the chip surface in the form of an array and of the connection part of a beam lead and the semiconductor chip in the assembly thereof;
Fig. 4 is a sectional view of the schematic configuration of a semiconductor device according to a first embodiment of the invention;
Fig. 5 is a sectional view of assembly steps of the semiconductor device according to the first embodiment showing the state up to the formation of solder bumps on a semiconductor wafer;
Fig. 6 is a sectional view of the state after the division of the semiconductor wafer into chips continuing from Fig. 5;
Fig. 7 is a sectional view of the connection step of a polyimide tape and the solder bumps continuing from Fig. 6;
Figs. 8A and 8B are views of a manufacturing process of a semiconductor device according to a second embodiment of the invention showing an injection step of resin to a semiconductor wafer in which a polyimide tape is connected over individual chip regions;
Fig. 9 is a sectional view of the state after the formation of the solder balls continuing from Figs. 8A and 8B; and
Fig. 10 is a sectional view of an adhesion step of the polyimide tape in the assembly method according to a third embodiment of the invention.

### DESCRIPTION OF THE PREFERRED EMBODIMENTS

Below, preferred embodiments will be described with reference to the accompanying drawings.

### First Embodiment

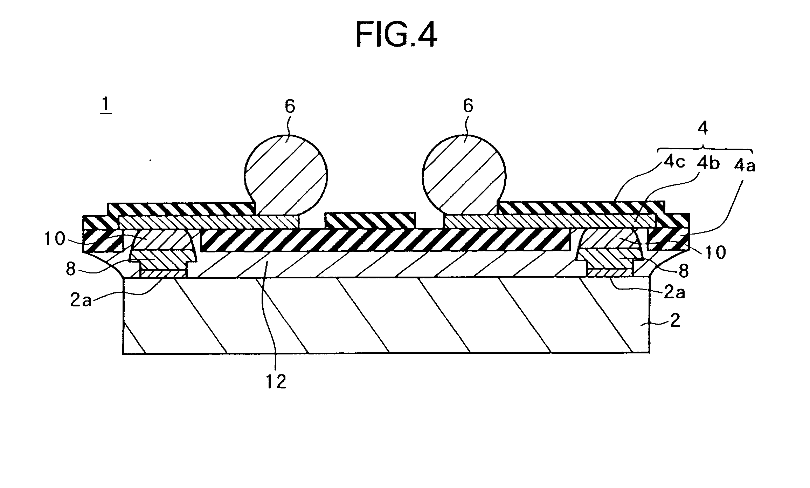

Figure 4 is a sectional view of the schematic configuration of a semiconductor device according to the present embodiment.

This semiconductor device 1 has a semiconductor chip 2, a polyimide tape 4, and external terminals 6.

The polyimide tape 4 has a three-layer structure of a conductive layer sandwiched between polyimide layers. Specifically, the polyimide tape 4 of the present embodiment comprises, as shown in Fig. 4, a polyimide (hereinafter abbreviated as "PI") tape substrate 4a made of polyimide, Cu wiring 4b which is formed on the PI tape substrate 4a in a predetermined pattern and to the surface of which for example an Ni/Au plating is applied, and a PI cover layer 4c formed on the Cu wiring 4b. The PI tape substrate 4a and the PI cover layer 4c have openings for partially exposing the predetermined pattern portions of the Cu wiring 4b.

The semiconductor chip 2 is connected to the polyimide tape 4 at a side of the element forming a surface side thereof. Specifically, in the present example, a barrier metal layer is formed on the pads 2a which are exposed at openings of a passivation film (not illustrated) covering the element forming surface of the semiconductor chip 2 and made of for example Al if necessary, a conductive UBM (under bump metal) layer 8 is formed on the barrier metal layer or pads 2a, and solder for forming a solder layer 10 is supplied onto the UBM layer 8 by dipping or the like. Then, the solder layer 10 on this UBM layer 8 is connected to the Cu wiring 4b of the polyimide tape 4 exposed at the openings of the PI tape substrate 4a by thermocompression bonding.

The UBM layer 8 is made of Au, Cu, Ni, or the like and formed by an electroless plating process or an electroplating process using the barrier metal layer as an electrode.

The barrier metal layer is used in a case where the UBM layer is composed of Au or the like other than the case where the electroplating process is used. In this case, as a material of the barrier metal layer, for example Ni or Ni/Pd is selected.

The external terminals 6 formed on the PI cover layer 4c side of the polyimide tape 4 are made of for example solder balls having a relatively large diameter and are arranged in an area on the polyimide tape surface in the form of a grid array. The solder balls are formed by for example a solder paste printing process or a solder ball process.

A resin layer 12 referred to as "underfill layer" is filled in the gap between the facing polyimide tape 4 and semiconductor chip 2. Due to this resin layer 12, the stress applied to the semiconductor chip 2 due to the difference in the thermal expansion coefficients between a mother board (not shown) and the semiconductor chip 2 is relieved in the state where the semiconductor device 1 is mounted on the mother board via the external terminals 6. As a result, variations in the characteristics of the semiconductor chip 2 and breakage of the external terminals 6 or internal terminals (UBM layer 8 and solder layer 10) are effectively prevented.

Furthermore, when the resin is filled before the formation of the external terminals 6, the resin layer 12 also prevents the breakage of the semiconductor chip 2 from the pressing force applied when forming the external terminals 6.

Next, an explanation will be made of the method for assembling this semiconductor device 1.

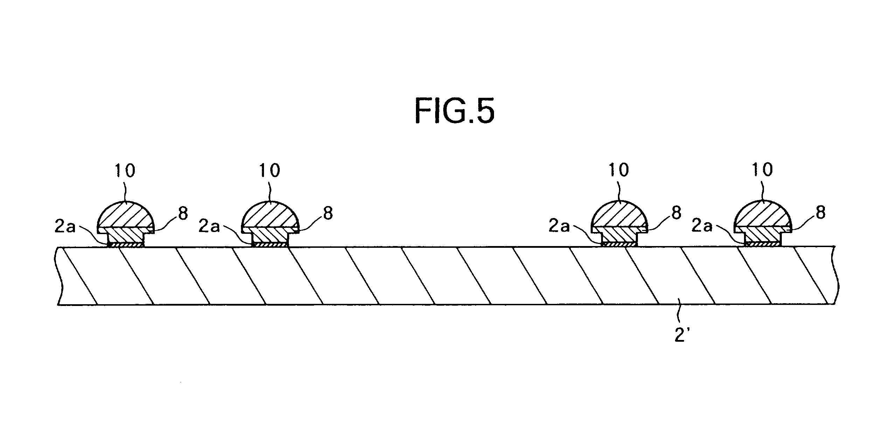

Figures 5 to 7 are sectional views of assembly processes of the semiconductor device according to the present embodiment.

In Fig. 5, reference numeral 2' denotes a semiconductor wafer before it is divided into semiconductor chips.

In this wafer state, after the barrier metal (not illustrated) layer is formed if necessary, as shown in Fig. 5, the UBM layer 8 is formed on the pads 2a exposed from the openings of the not illustrated passivation film by electroless plating or electroplating or the like.

Then, the solder layer 10 is formed on the UBM layer 8 by for example dipping, electroless plating, or electroplating.

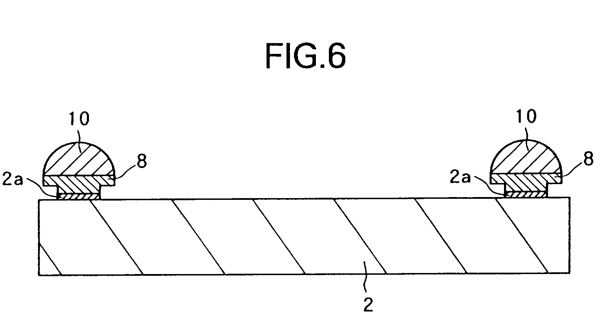

The semiconductor wafer 2' after supply of the solder is divided by using a dicing saw or the like to form the semiconductor chip 2 shown in Fig. 6.

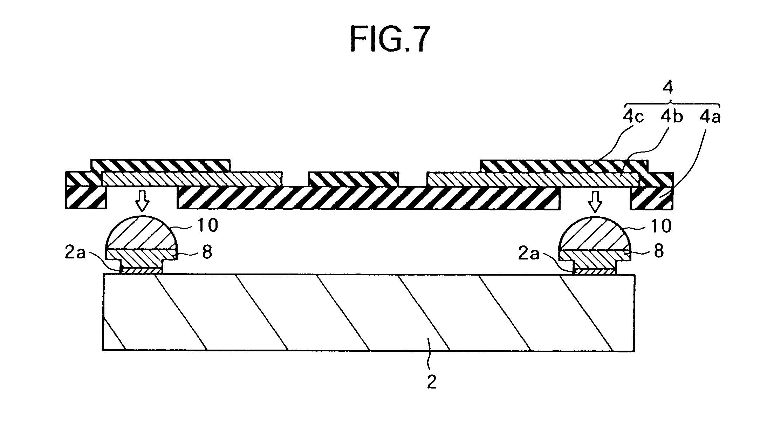

As shown in Fig. 7, a polyimide tape 4 formed in advance is moved to above the semiconductor chip 2 by a holding tool (jig) and positioned so that the openings of the PI tape substrate 4a of the polyimide tape 4 is positioned above the solder layer 10. The polyimide tape 4 is gently placed on the semiconductor chip 2, then the holding tool or another specialized tool is used to contact the polyimide tape 4 against the semiconductor chip 2 while heating it. The heating temperature at this time is about 320°C to 400°C where an Au/Sn eutectic alloy is formed. The polyimide tape 4 having a heat resistance enough to endure this temperature is used. Preferably, using as the tool at the time of thermocompression bonding or the support stand of the chip elastic ones, for example, ones where a heat resistant (tolerance) rubber or the like is interposed, so as to prevent more than the necessary pressure from being applied is desirable in view of the protection of the semiconductor chip.

Next, as shown in Fig. 4, resin melted by heating is injected into the gap between the polyimide tape 4 and the semiconductor chip 2 to form the resin layer 12.

After cooling, the solder balls are formed above the openings of the PI cover layer 4c of the polyimide tape 4 as the external terminals 6 by for example a solder paste printing process or a solder ball process.

In the solder paste printing process, a carrier tape on which the solder paste is printed is brought into contact with the top of the polyimide tape 4, the solder paste is thermally transferred to the polyimide tape 4 side by the thermocompression bonding, the carrier tape is peeled off, and then reflow is carried out. Alternatively, in the solder ball process, the solder balls formed in advance are moved to predetermined locations on the polyimide tape 4 by a specialized tool and then reflow is carried out. In any of the above processes, in order to form the solder balls high enough by reflow, the method of covering the periphery by flux or solder resist or the like in advance is employed.

In a conventional CSP using a polyimide tape, a buffer member referred to as an elastomer is interposed, the periphery of the elastomer is sealed by a resin, and the polyimide tape inside the CSP and the semiconductor chip are connected by interposing Au pellets at S-shaped beam lead terminals. Contrary to this, in the semiconductor device according to the present embodiment and the method of assembling the same, the buffer effect is sufficient even by just resin sealing, so the elastomer is omitted and electrical connection was carried out together at the time of adhesion of the polyimide tape and the semiconductor chip. As a result, the material cost of the elastomer and assembly time and cost can be reduced.

Furthermore, since the polyimide tape and the semiconductor chip are connected by solder, the pressing force can be reduced from that of the case by the thermocompression bonding of the Au pellets. As a result, the occurrence of the cracks in the semiconductor chip can be effectively prevented. Particularly, even in the case where the pads of the semiconductor chip are arranged on the element forming portion in the form of a grid array, breakage of elements due to the occurrence of cracks can be effectively prevented.

### Second Embodiment

A second embodiment relates to a method of assembling a semiconductor device performed in the wafer state.

In the present embodiment, the chip dividing process in Fig. 6 of the first embodiment is carried out after the assembly of the CSP semiconductor device. This assembly method is the same as the method shown in Fig. 7 and explained in the first embodiment until the polyimide tape 4 and the semiconductor chip 2 (semiconductor wafer 2' in the present embodiment).

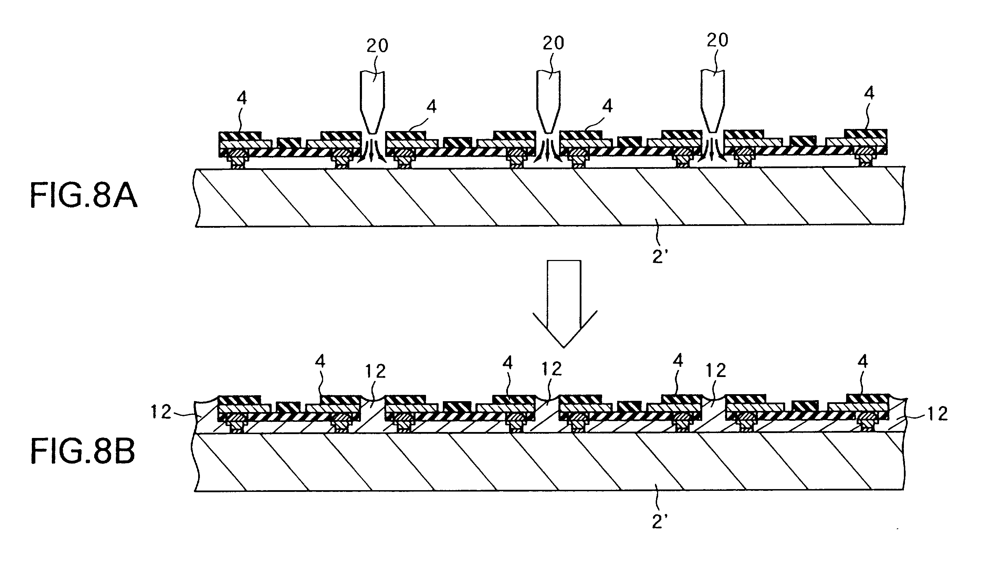

Figures 8A and 8B are views showing the processes of injecting resin for forming the resin layer 12 on to a semiconductor wafer 2' in which the polyimide tape 4 is connected to individual chip regions.

In the injection process of the resin of the present embodiment, as shown in Fig. 8A, a dispenser 20 for injecting the resin is used, the front end of the nozzle of the dispenser is positioned near the side surface of the polyimide tape 4 apart from it on a scribe line of the semiconductor chip, and a resin for forming the resin layer 12 melted by heating is injected from this nozzle end of the dispenser 20. As a result, the resin 12 enters into the gap (interval) between the polyimide tape 4 and the semiconductor wafer 2' in the chip regions at the two sides of the scribe line. As shown in Fig. 8B, the interval is filled by the resin 12.

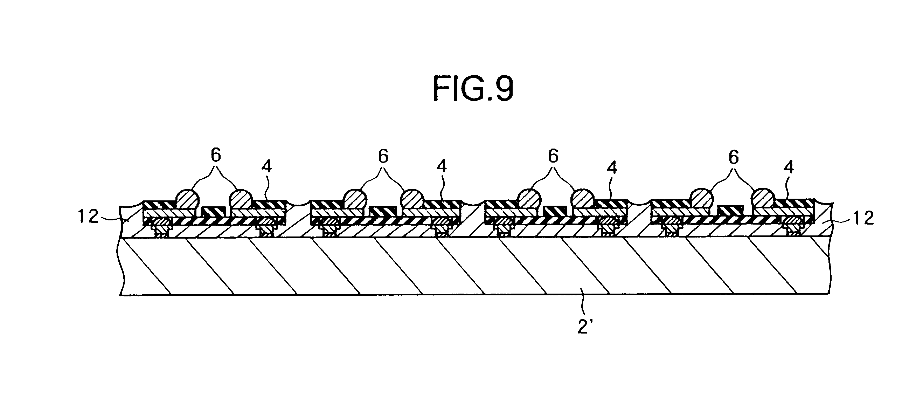

After filling the resin, the solder balls serving as the external terminals 6 are formed for example together while in the wafer state. The situation after the formation of the solder balls is shown in Fig. 9.

Thereafter, the chips are separated by a dicing saw or the like. At this time, the resin part on the scribe line is divided. The production of semiconductor devices is completed by this.

In the present embodiment, since the semiconductor wafer state is kept until the chips are finally separated, there are the advantages that the handling is easy, the adhesion of the polyimide tape 4, sealing of the resin, and the formation of the external terminals can be carried out together in units of predetermined areas, i.e., several chip regions, by specially designing the tool, and, therefore, the assembly cost can be further reduced.

### Third Embodiment

A third embodiment relates to another assembly method of a semiconductor device performed in the wafer state.

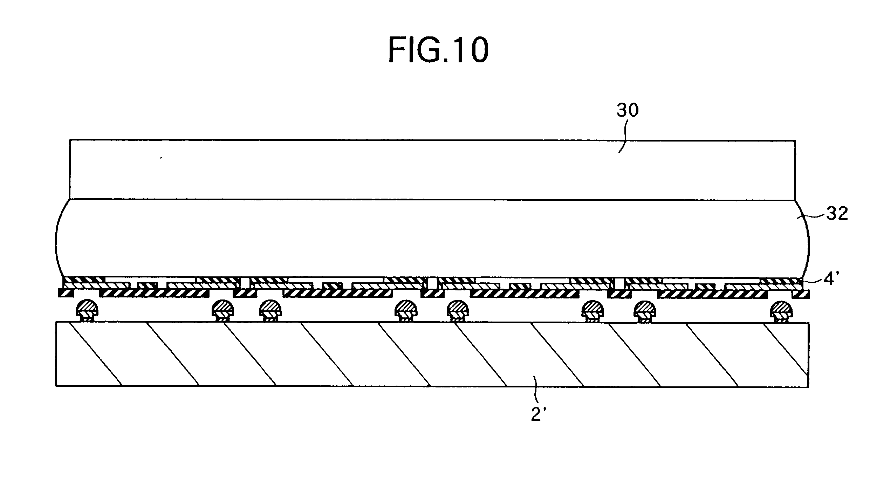

Figure 10 is a sectional view of the process of adhering the polyimide tape in the assembly method according to the present embodiment.

The polyimide tape 4' used in the present embodiment is connected over the entire wafer or to every predetermined area of several chip regions as shown in Fig. 10. Then, this polyimide tape 4' is thermocompression bonded onto the semiconductor wafer 2' by using a tool 30 having for example heat resistant (tolerance) rubber or another elastic member 32.

The polyimide tape 4' connecting over a plurality of chip regions is formed with, although not illustrated, a resin injection hole at a region above for example the predetermined scribe line. The nozzle of the dispenser 20 shown in Figs. 8A and 8B is inserted into this hole to inject the resin 12..

Furthermore, at the time of cutting the wafer into chips, the polyimide tape 4' is divided into pieces having the same size as the chips along with the semiconductor wafer 2' and the resin 12.

In the present embodiment, in the same way as the second embodiment, it is possible to perform the packaging in the semiconductor processing step. Furthermore, in comparison with the second embodiment, there are the advantages that since the polyimide tape 4' connects over a plurality of chip regions, the handling is easy, the thermocompression bonding of the polyimide tape 4' can be carried out together among a plurality of chips, and, accordingly, in the entire wafer, the assembly cost can be further reduced from that by the second embodiment by that amount.

When assembling a semiconductor device of a type using a polyimide tape as the intermediate substrate for providing the external terminals, the material cost thereof and the number of manufacturing steps are reduced, so it becomes possible to achieve a reduction of the costs.

Furthermore, during assembly, an application of mechanical shock is prevented from being applied to the semiconductor chip as much as possible, thereby preventing variations in characteristics and breakage of the semiconductor device. As a result, it has become possible to improve the yield and the reliability.

While the invention has been described with reference to specific embodiment chosen for purpose of illustration, it should be apparent that numerous modifications could be made thereto by those skilled in the art without departing from the basic concept and scope of the invention.

## Claims

1. A semiconductor device comprising a semiconductor chip (2) and an external terminal (6) electrically connected to the semiconductor chip (2) via a polyimide tape (4) having a conductive layer (4b) and two polyimide layers (4a, 4c) with the conductive layer (4b) sandwiched therebetween,
said external terminal (6) for electrical connection to said conductive layer (4b) of the polyimide tape (4) being provided on one surface of the polyimide tape (4), and
a pad (2a) of the semiconductor chip (2) and the conductive layer (4b) of the polyimide tape (4) being connected by solder (10) on the other surface of the polyimide tape (4).

2. A semiconductor device as set forth in claim 1, wherein a resin (12) is filled in the entire area inside a gap of the facing semiconductor chip (2) and polyimide tape (4) including the periphery of the connection positions of the semiconductor chip (2) and the polyimide tape (4).

3. A method for assembling a semiconductor device in which an external terminal (6) is electrically connected to a semiconductor chip (2) via a polyimide tape (4) having a conductive layer (4b) and two polyimide layers (4a, 4c) with the conductive layer (4b) sandwiched therebetween, including the steps of:
supplying solder (10) onto a pad (2a) of the semiconductor chip (2) or an electrode layer (8) provided on the pad (2a);
positioning so that a predetermined location of the conductive layer (4b) exposed at one surface of the polyimide tape (4) is positioned on top of the solder (10); and
connecting the polyimide tape (4) and the semiconductor chip (2) by thennocompression bonding.

4. A method for assembling a semiconductor device as set forth in claim 3, further including the steps of:
filling a resin (12) in the entire area inside a gap of the facing semiconductor chip (2) and polyimide tape (4) including the periphery of the connection positions of the semiconductor chip (2) and the polyimide tape (4) and
forming an external terminal (6) at a predetermined location of the conductive layer (4b) exposed at the other surface of the polyimide tape (4).

5. A method for assembling a semiconductor device in which an external terminal (6) is electrically connected to a semiconductor chip (2) via a polyimide tap (4) having a conductive layer (4b) and two polyimide layers (4a, 4c) with the conductive layer (4b) sandwiched therebetween, including the steps of:
supplying solder (10) onto a pad (2a) in the state of the semiconductor wafer (2') before being divided into chips or an electrode layer (8) provided on the pad (2a),
positioning so that a predetermined location of the conductive layer (4b) exposed at one surface of the polyimide tape (4) is positioned on top of the solder (10);
connecting the polyimide tape (4) and the semiconductor chip (2) by thennocompression bonding; and
dividing the semiconductor wafer (2') into chips.

6. A method for assembling a semiconductor device as set forth in claim 5, wherein, in the connection step of the polyimide tape (4) and the semiconductor wafer (2'), a plurality of polyimide tapes (4) is used to divide into chip regions of the semiconductor wafer (2').

7. A method for assembling a semiconductor device as set forth in claim 5, wherein,
in the connection step of the polyimide tape (4') and the semiconductor wafer (2'), a single polyimide tape (4') connecting over the entire area of the semiconductor wafer (2') is used and,
in the step of dividing the semiconductor wafer (2') into chips, the polyimide tape (4') is divided together with the semiconductor wafer (2').

8. A method for assembling a semiconductor device as set forth in claim 5, wherein, in the connection step of the polyimide tape (4) and the semiconductor wafer (2'), when holding one of the polyimide tape (4) and the semiconductor wafer (2') and pressing the same against the other, a tool having such an elasticity that it absorbs a repulsion force due to pressing to a certain extent is used.

9. A method for assembling a semiconductor device as set forth in claim 5, wherein, in the connection step of the polyimide tape (4) and the semiconductor wafer (2'), when holding one of the polyimide tape (4) and the semiconductor wafer (2') and pressing the same against the other on a support stand, a support stand having such an elasticity that it absorbs a repulsion force due to pressing to a certain extent is used.

10. A method for assembling a semiconductor device as set forth in claim 5, further including the steps of:
filling a resin (12) in the entire area inside a gap of the facing semiconductor wafer (2') and polyimide tape (4) including the periphery of the connection positions of the semiconductor wafer (2') and the polyimide tape (4); and
forming an external terminal (6) at a predetermined location of the conductive layer (4b) exposed at the other surface of the polyimide tape (4).

11. A method for assembling a semiconductor device as set forth in claim 10, wherein,
in the resin filling step, a plurality of resin injecting nozzles are used to inject resin (12) all together on the entire surface of the semiconductor wafer (2') or for a plurality of chip regions in a predetermined area and,
in the step of dividing the semiconductor wafer (2') into chips, the resin part (12) between chip regions is cut together with the semiconductor wafer (2').

12. A semiconductor device comprising:
a semiconductor chip (2);
an electrical-conductive portion having a pad (2a) formed on the surface of the semiconductor chip (2), a bump metal layer (8) formed on the pad (2a) and a solder layer (10) formed on the bump metal layer (8);
an intermediate electrical-conductive member (4) having an electrical conductive layer (4b) and first and second insulation layers (4a, 4c) formed on both surfaces of the electrical conductive layer (4b), and facing the surface of the semiconductor chip (2);
an insulation resin (12) inserted into a gap between the semiconductor chip (2) and the intermediate electrical-conductive member (4b); and
an external terminal (6),
one surface of the electrical conductive layer (4b) of the intermediate electrical-conductive member (4) being connected to the solder layer (10) of the electrical-conductive portion (4b) through an opening formed in the first insulation layer (4a) of the intermediate electrical-conductive member (4), and another surface of the electrical-conductive layer (4b) of the intermediate electrical-conductive member (4) being connected to the external terminal (6) through another opening formed in the second insulation layer (4c) of the intermediate electrical-conductive member (4).

13. A semiconductor device according to claim 12, wherein the electrical-conductive portion (4b) comprises a barrier metal layer (8) formed between the surface of the semiconductor chip (2) and the pad (2a).

14. A semiconductor device according to claim 12, wherein the first and second insulation layers (4a. 4c) are formed by polyimide.

15. A semiconductor device according to claim 12, wherein the external terminal (6) is formed by solder material.

16. A semiconductor device according to claim 12, wherein a plurality of electrical-conductive portions (4b) are arranged in a grid array form on element forming regions of the semiconductor chip (2).
